# EUROPEAN PATENT APPLICATION

(11) **EP 3 984 945 A1**
(43) Date of publication of application: **20.04.2022**
(21) Application number: 20201872.7
(22) Date of filing: 14.10.2020
(51) Int. Cl.: B81C 1/00, G01N 33/00, G01N 21/17

(54) **METHOD FOR MANUFACTURING AN EMITTER PACKAGE FOR A PHOTOACOUSTIC SENSOR ASSEMBLY**

(71) Applicant: Infineon Technologies AG, 85579 Neubiberg (DE)
(72) Inventor: QI, Siyuan, East Grinstead, RH19 3HB (GB); Maier, Dominic, 92714 Pleystein (DE); PAVIER, Mark, Felbridge, RH19 2PP (GB)
(74) Representative: Stöckeler, Ferdinand

(57) **Abstract**

This disclosure concerns an emitter package (100) and a method (400) for manufacturing an emitter package (100) for a photoacoustic sensor assembly (1000). The method (400) comprises a step of providing a substrate (110) having a first main surface (101), an opposite second main surface (102), a vent hole (150, 150') extending between the first main surface (101) and the second main surface (102) of the substrate (110), a step of placing a MEMS infrared radiation source (120) onto the first main surface (101) of the substrate (110), a step of providing a cavity structure (130) comprising a cavity (131) being surrounded by a lateral side wall structure (132) and a silicon lid (134), a step of applying an adhesive (140) between the first main surface (101) and the lateral side wall structure (132) and positioning the lateral side wall structure (132) on the adhesive (140), such that the MEMS infrared radiation source (120) is arranged inside said cavity (131), and such that the lateral side wall structure (132) laterally surrounds the vent hole (150, 150'), and a step of curing the adhesive (140).

## Description

### GENERAL DESCRIPTION

Embodiments of the present disclosure relate to a method for manufacturing an emitter package for a photoacoustic sensor assembly, an emitter package for a photoacoustic sensor assembly and a photoacoustic emitter assembly with such an emitter package.

### TECHNICAL BACKGROUND

The present disclosure is concerned with photoacoustic sensors, and in particular with an emitter package that can be used in a photoacoustic sensor. The so-called photo acoustic effect represents the transformation of pulsed radiation energy into sound. PAS (photo acoustic spectroscopy) concepts can be used for gas sensors, e.g. for CO₂ gas sensors. Such gas sensors may comprise a PAS emitter package containing a MEMS die that emits a pulsed infrared (IR) signal. For example, a PAS emitter package may generate an IR signal with a wavelength of ∼ 4.2 µm which is absorbed by CO₂ gas molecules. The absorbed energy causes local heating and a pressure change in the gas sensor that can be detected by a pressure difference detector. This may be a sound transducer, e.g. a silicon microphone. The signal generated by the pressure difference detector correlates with the CO₂ concentration in the ambient air.

In order to detect a pressure change in the PAS CO₂ gas sensor module accurately, all glued interfaces of the PAS emitter package soldered inside the PAS sensor module shall be acoustically tight without significant delamination or voiding. There may be two distinct adhering steps, wherein a first one concerns the attachment of the package's lid to the package's side wall, while a second one concerns the attachment of the package's side wall to the substrate at which the emitter package may be placed.

Accordingly, if glue is used there may be two consequent glue cure processes in a PAS emitter assembly. Glue cure No. 1 (lid to side wall glue cure) is done first and followed by glue cure No. 2 (side wall to substrate glue cure). Using a standard cavity package, it was found that during glue cure No. 2 significant blowholes occurred in the glue during and after curing. This may derive from the manufacturing processes that are currently used in cavity based emitter packages.

Thus, it is an object of the herewith disclosed innovative principle to provide an improved method for manufacturing an emitter package for a photoacoustic sensor assembly which avoids the above mentioned drawbacks of blowhole formation in the glue, so that the emitter package is tightly sealed and securely adhered to the substrate of the photoacoustic sensor assembly.

Therefore, according to an aspect of the herein described innovative principle, it is suggested to provide a method for manufacturing an emitter package for a photoacoustic sensor assembly, wherein the method comprises, inter alia, a step of providing a substrate having a first main surface, an opposite second main surface, and a vent hole being provided in the substrate, the vent hole extending between the first and second main surfaces. A MEMS (MEMS: micro electro mechanical system) infrared radiation source may be placed or mounted onto the first main surface of the substrate. The method further comprises a step of providing a cavity structure comprising a cavity being surrounded by a lateral side wall structure. An adhesive may be applied at an interface between the first main surface of the substrate and the lateral side wall structure. The lateral side wall structure may be positioned on the adhesive, such that the MEMS infrared radiation source is arranged inside said cavity and such that the lateral side wall structure laterally surrounds the vent hole. The method may further comprise a step of curing the adhesive.

According to a further aspect of the herein described innovative principle, it is suggested to provide an emitter package for a photoacoustic sensor assembly, the emitter package comprising a substrate having a first main surface and an opposite second main surface, a MEMS infrared radiation source arranged at the first main surface of the substrate and a cavity structure comprising a cavity being surrounded by a lateral side wall structure. The lateral side wall structure may be adhered to the first main surface of the substrate by means of a cured adhesive, such that the MEMS infrared radiation source is arranged inside said cavity. The emitter package may further comprise a vent hole formed in the substrate, the vent hole extending between the first main surface and the second main surface, wherein the vent hole is laterally surrounded by the lateral side wall structure.

In the following, embodiments of the present disclosure are described in more detail with reference to the figures, in which,
- Fig. 1A: shows a schematic cross-sectional view of an emitter package assembly that may be manufactured by a method according to an embodiment,
- Fig. 1B: shows a top view of an emitter package that may be manufactured by a method according to an embodiment,
- Fig. 2: shows a block diagram of a method according to an embodiment,
- Figs. 3A-3C: show schematic cross-sectional views of an emitter package assembly that may be manufactured by a conventional method,
- Fig. 4: shows enlarged microscopic images of the adhesive bond of emitter pack-ages being manufactured by conventional methods,
- Fig. 5A: shows a cross-sectional three-dimensional view of an emitter package that may be manufactured by a method according to an embodiment,
- Fig. 5B: shows a cross-sectional view of an emitter package that may be manufactured by a method according to an embodiment,
- Fig. 5C: shows an enlarged microscopic image of an adhesive bond of an emitter package being manufactured by conventional methods,
- Fig. 5D: shows an enlarged microscopic image of an adhesive bond of an emitter package being manufactured by the herein described innovative method according to an embodiment,
- Fig. 6: shows a top view onto a perforated membrane that may form part of the MEMS IR radiation source of the emitter package according to an embodiment,
- Fig. 7A: shows a cross-sectional view of an emitter package that may be manufactured by a method according to an embodiment,
- Fig. 7B: shows a bottom view of an emitter package that may be manufactured by a method according to an embodiment,
- Fig. 8: shows a schematic cross-sectional view of a photoacoustic sensor assembly comprising an emitter package that may be manufactured by a method according to an embodiment,
- Fig. 9A: shows an enlarged microscopic image of solder material being provided at an interface between the substrate of the emitter package and the substrate of the photoacoustic sensor assembly,
- Fig. 9B: shows an enlarged microscopic image of an emitter package according to an embodiment being assembled in a photoacoustic sensor assembly,
- Fig. 9C: shows a further enlarged microscopic image of solder material being provided at an interface between the substrate of the emitter package and the substrate of the photoacoustic sensor assembly, and
- Fig. 9D: shows a further enlarged microscopic image of solder material being provided at an interface between the substrate of the emitter package and the substrate of the photoacoustic sensor assembly.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

If the term "air" is mentioned therein it can be understood as ambient air comprising a mixture of gases. Said ambient air may comprise a gas to be detected by the photoacoustic sensor assembly according to the herein described innovative principle. The gas to be detected may also be referred to as an analyte.

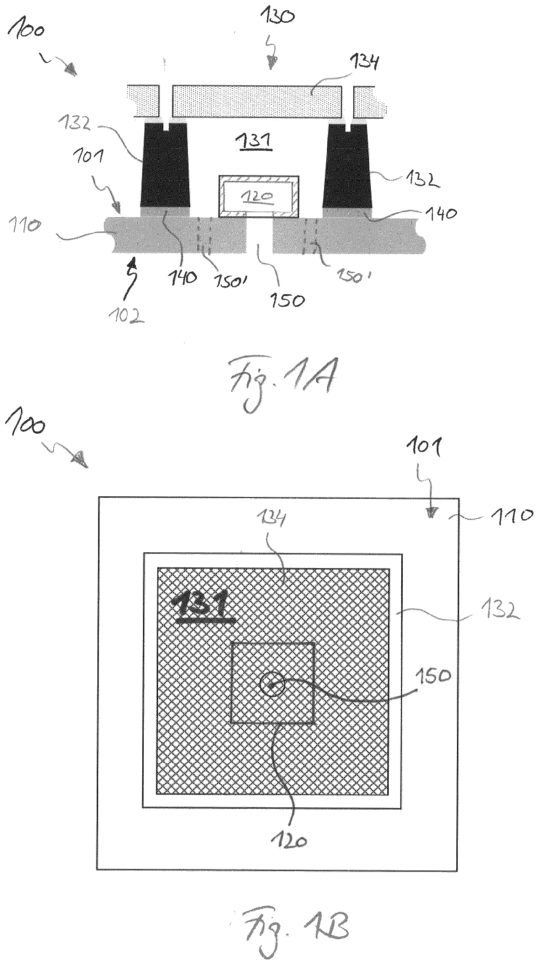

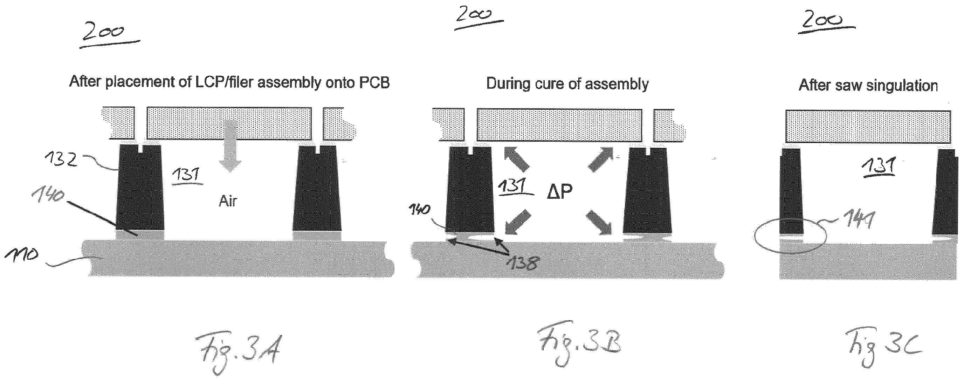

For the following description of the herein disclosed innovative principle it is firstly referred to Figures 1A and 1B as well as to Figures 3A to 3C, wherein Figures 1A and 1B show a schematic sectional side view and a top view, respectively, of an emitter package 100 according to the herein described innovative principle while Figures 3A to 3C show schematic examples to visualize the formation of undesired blowholes and air channels in the adhesive during and after curing, when the depicted emitter package 100 is manufactured using conventional methods.

The emitter package 100 comprises a substrate 110. The substrate 110 may comprise or be configured as a laminate substrate, e.g. a PCB (Printed Circuit Board).

The substrate 110 comprises a first main surface 101 and an opposite second main surface 102. A MEMS (MEMS: micro electro mechanical system) infrared radiation (IR) source 120 may be placed/mounted onto the first main surface 101 of the substrate 110.

A cavity structure 130 is provided that comprises a cavity 131 being surrounded by a lateral side wall structure 132. The lateral side wall structure 132 may comprise or be made from an LCP (Liquid Crystal Polymer).

An adhesive 140 may be applied between the first main surface 101 of the substrate 110 and the lateral side wall structure 132. The lateral side wall structure 132 of the cavity structure 130 may be placed onto the first main surface 101 such that the lateral side wall structure 132 laterally surrounds the MEMS infrared radiation source 120. Accordingly, the MEMS infrared radiation source 120 may be arranged or housed inside said cavity 131.

As can be seen in the top view in Figure 1B, the lateral side wall structure 132 may comprise adjacent, and preferably contiguous, lateral side walls substantially extending perpendicular to the first and second main surfaces 101, 102 of the substrate 110. Thus, the lateral side walls may also be referred to as vertical side walls, and the lateral side wall structure 132 may also be referred to as a vertical side wall structure. There may be a mold release angle on the internal side (i.e. the side of the walls facing the inner cavity 131) of the lateral side wall structure 132. The mold release angle may have a nominal value between 2° to 5° which may help to release the mold in the inside of the cavity 131.

The lateral (vertical) walls of the lateral (vertical) side wall structure 132 may encircle and/or enclose the MEMS IR radiation source 120. In other words, the lateral walls of the lateral side wall structure 132 may provide or form a cavity 131 inside of which the MEMS IR radiation source 120 may be arranged.

Optionally, a lid structure 134 may be placed on top of the lateral side walls of the lateral side wall structure 132. The lid 134 may comprise or be made from silicon. The lid 134 may be placed at the top side of the lateral side wall structure 132, i.e. at the side of the vertical wall structure 132 which is opposite the first main surface 101 of the substrate 110. The lid 134 may be parallel to the first main surface 101. The underside of the lid 134, i.e. the side which faces into the cavity 131, may face the first main surface 101.

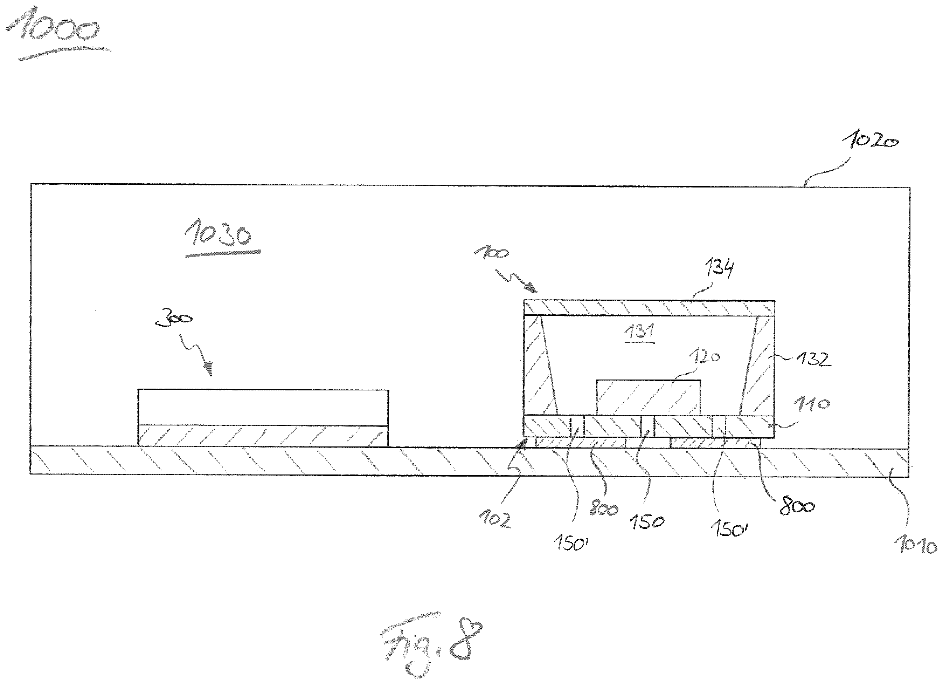

The lid 134 together with the lateral side wall structure 132 may form an enclosed cavity 131, in particular when the lateral side wall structure 132 is mounted onto the substrate 110, as shown in Figures 1A and 1B. The lid 134 may optionally comprise a filter structure for filtering infrared light of a certain wavelength. For instance, if CO₂ is the gas of interest of the photoacoustic sensor assembly 1000 (Figure 8), then infrared light having a wavelength of ∼ 4.2 µm may be suitable for the detection of CO₂, and accordingly, the optional filter structure may be configured to let light of a predetermined wavelength pass through the lid structure 134. In Figure 1B, the lid structure 134 is shown in crossed lines.

The emitter package 100 may further comprise a vent hole 150, 150' that is provided in the substrate 110. The vent hole 150, 150' may extend between the first main surface 101 of the substrate 110 and the second main surface 102 of the substrate 110. As can be seen, the vent hole 150, 150' may be positioned at different locations in the substrate 110.

For example, the vent hole 150 may be positioned underneath the MEMS infrared radiation source 120, in particular when viewed from the top (i.e. directly viewed perpendicular to the first main surface 101 of the substrate), as depicted in Figure 1B and indicated with reference numeral 150. In other words, the MEMS infrared radiation source 120 may be placed at a region of the first main surface 101 of the substrate 110 at which the vent hole 150 is provided. Stated in yet other terms, the MEMS infrared radiation source 120 may cover the vent hole 150, particularly when viewed from above, such as shown in Figure 1B. Accordingly, the MEMS infrared radiation source 120 may be placed above or over the vent hole 150.

Alternatively, the vent hole 150' may be positioned adjacent to the MEMS infrared radiation source 120, which is indicated with reference numeral 150'.

In more general terms, the vent hole 150, 150' may be positioned inside the inner contour of the side walls of the lateral side wall structure 132, in particular when viewed from the top. That is, the vent hole 150, 150' may be positioned inside the lateral side wall structure 132. Or stated the other way around, the lateral side wall structure 132 may laterally surround or circumvent the vent hole 150, 150'.

The MEMS infrared radiation source 120 may be placed directly onto the first main surface 101 of the substrate 110, i.e. without any further elements therebetween. Accordingly, if the MEMS infrared radiation source 120 is placed above the vent hole 150, then the vent hole 150 may be in fluid connection with the MEMS infrared radiation source 120, and (via the MEMS infrared radiation source 120) with the inner cavity 131 being formed by the lateral side wall structure 132. If the MEMS infrared radiation source 120 is placed adjacent to the vent hole (see reference numeral 150'), then the vent hole 150' may be at least in fluid connection with the inner cavity 131 formed by the lateral side wall structure 132.

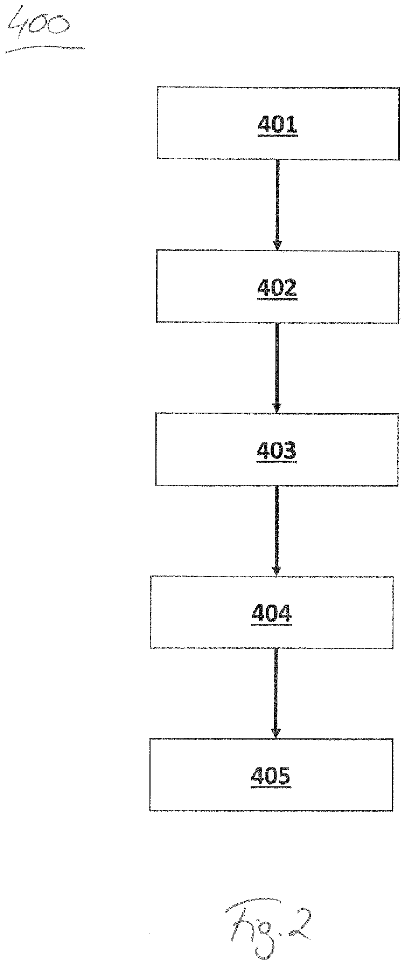

Having described the structure of the emitter package 100, Figure 2 shows a schematic block diagram of a method 400 for manufacturing an emitter package 100 according to the herein described innovative principle. The method steps may be executed in a chronological order different from the depicted order.

In step 401 a substrate 110 may be provided, the substrate 110 having a first main surface 101, an opposite second main surface 102, and a vent hole 150 being formed or provided in the substrate 110, the vent hole 150 extending between the first main surface 101 of the substrate 110 and the second main surface 102 of the substrate 110.

In step 402 a MEMS (MEMS: micro electro mechanical system) infrared radiation source 120 may be placed/mounted onto the first main surface 101 of the substrate 110, particularly in a manner such that the MEMS infrared radiation source 120 is mounted above the vent hole 150 or adjacent the vent hole 150'.

In step 403 a cavity structure 130 may be provided, the cavity structure 130 comprising a cavity 131 being surrounded or formed by a lateral side wall structure 132.

In step 404 an adhesive 140 may be applied between the first main surface 101 and the lateral side wall structure 132, and the lateral side wall structure 132 may be positioned on the adhesive 140, such that the MEMS infrared radiation source 120 is arranged inside said cavity 131.

The vent hole 150, 150' may be in fluid connection with the cavity 131.

In step 405 the adhesive 140 may be cured. For example, the adhesive may be cured by applying heat and/or UV (ultraviolet) radiation. In particular, if heat is applied for curing the adhesive, air trapped inside the cavity 131 may expand due to the induced heat which also heats said air inside the cavity 131.

Figures 3A to 3C show the effect of the expanding air on an emitter package 200 if manufactured by conventional methods. As can be seen, a conventionally manufactured emitter package 200 does not comprise the above described vent hole 150, 150'.

Figure 3A shows an assembled state of the conventional emitter package 200 prior to curing the adhesive 140 between the lateral side wall structure 132 and the substrate 110. This state may show the conventional emitter package 200 at room temperature.

Figure 3B shows a state in which heat is applied for curing the adhesive 140. The air inside the cavity 131 expands due to the applied heat. Accordingly, the pressure inside the cavity 131 increases. Furthermore, solvent from the adhesive 140 may outgas from the adhesive 140 upon appliance of heat. These outgassed solvents may further increase the pressure inside the cavity 131. This leads to an undesired displacement of the adhesive 140, indicated with reference numeral 138. For example, the adhesive 140 may be pushed laterally outwards.

Figure 3C shows a state of the conventional emitter package 200 after being singulated, e.g. by means of saw singulation. As can be seen, the above mentioned displacement of the adhesive 140 leads to a formation of undesired voids and air channels 141 in the adhesive 140. These voids and air channels 141 may cause an undesired leakage of acoustic sound waves and light from inside the cavity 131 to the outside environment thereby degrading the performance of the entire photoacoustic sensor assembly 1000.

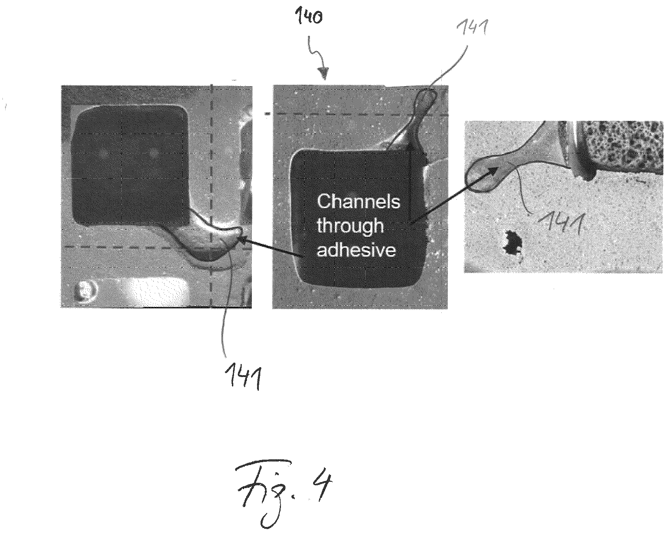

Figure 4 shows some enlarged microscopic images of the above described undesired voids and channels 141 being formed in the adhesive 140 after curing the adhesive 140 by applying heat. Again, this concerns conventional emitter packages 200 being manufactured by conventional methods.

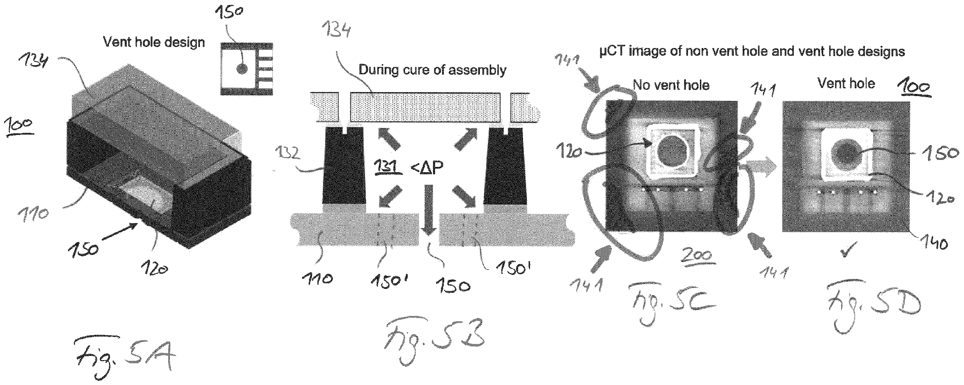

In order to solve this problem, the herein described innovative principle suggests a substrate 110 comprising the above described vent hole 150, 150'. In order to clearly show the difference and the positive effect of the present innovative concept over the conventional methods, reference is made to Figures 5A to 5D.

Figure 5A shows a schematic sectional 3D view of an emitter package 100 according to the herein described innovative principle.

As can be seen in Figure 5B, when curing the adhesive 140, for instance by applying heat, air (and solvent) inside the cavity 131 may expand, thereby increasing the pressure inside the cavity 131, as mentioned before. However, the vent hole 150, 150' provided in the substrate 110 serves the purpose of relieving the increased pressure inside the cavity 131.

As a consequence, the emitter package 100 according to the herein described innovative principle may comprise significantly less voids and air channels 141 compared to conventional emitter packages 200 as described above. The herein described innovative method for manufacturing an emitter package 100 may allow to have an adhesive bond between the lateral side wall structure 140 and the substrate 110, wherein the adhesive 140 is substantially free from voids and air channels 141, such that the adhesive bond is stable and the emitter package 100 is tightly sealed against leakage of sound waves and light towards the surrounding environment.

Figure 5C shows a micro CT image of a conventional emitter package 200 having a substrate without the vent hole 150, while Figure 5D shows a micro CT image of an emitter package 100 according to the herein described innovative concept comprising the vent hole 150. As can be seen in Figure 5C, the adhesive 140 applied at the conventional emitter package 200 comprises irregularities as well as voids and air channels 141 (highlighted in hatched lines). As can be seen in Figure 5D, the adhesive 140 applied to the emitter package 100 of the present concept comprises significantly less irregularities. Instead, the adhesive 140 is applied very regularly and smooth all around the interface between the substrate 110 and the lateral side wall structure 132. In other words, the adhesive 140 shows no significant voids present at the side wall structure 132 (e.g. LCP) to substrate 110 (e.g. PCB) assembly.

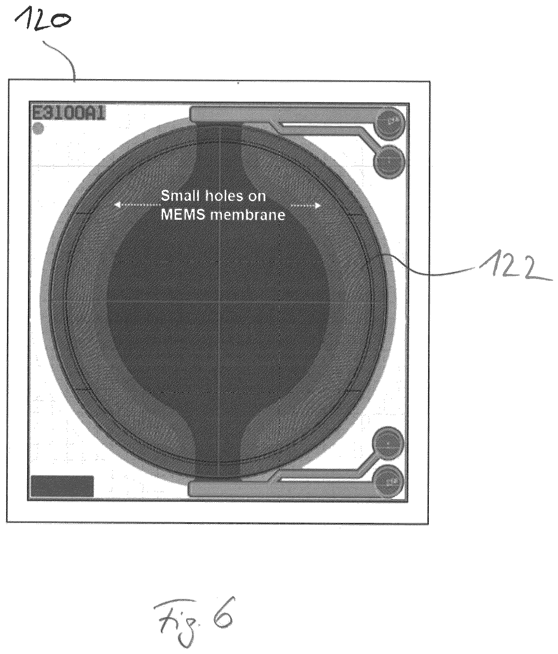

Figure 6 shows a top view of a MEMS IR radiation source 120 that may be used in and/or form part of the emitter package 100 according to the herein described innovative concept. The MEMS IR radiation source 120 may comprise a heat dissipating membrane 122. The heat dissipating membrane 122 may be configured to dissipate infrared radiation to be used for the photoacoustic sensing principle of the photoacoustic sensor assembly 1000.

As shown in Figures 1A and 5A, the MEMS IR radiation source 120 may be attached to the first main surface 101 of the substrate 110, e.g. by means of an adhesive 140. Thus, the MEMS IR radiation source 120 may be attached to the substrate 110 in a manner to be sealed against leakage of sound waves and light. However, in order to allow the increased pressure inside the cavity 131 to reach the vent hole 150 underneath the MEMS IR radiation source 120, the air trapped inside the cavity 131 is allowed to flow through small holes provided in the heat dissipating membrane 122 into the inside of the MEMS IR radiation source 120 and, in consequence, into the vent hole 150 underneath the MEMS IR radiation source 120. Thus, the heat dissipating membrane 122 may comprise or be provided as a perforated membrane structure.

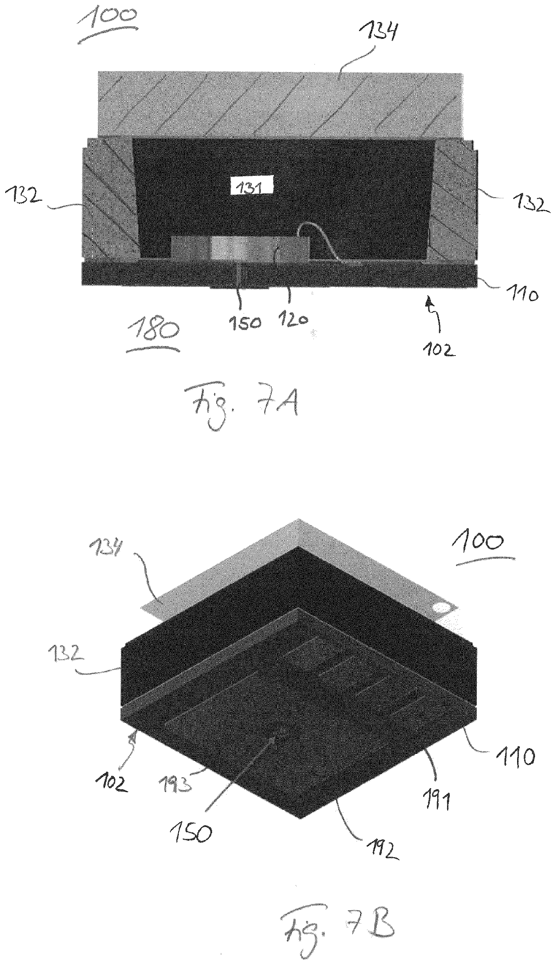

Figures 7A and 7B show some further exemplary embodiments of an emitter package 100 according to the herein described innovative principle. Figure 7A shows a cross-sectional view. In this non-limiting example, the vent hole 150 is formed inside the substrate 110 underneath the MEMS IR radiation source 120. However, as mentioned before the vent hole 150' may additionally or alternatively also be provided next to or adjacent to the MEMS IR radiation source 120. However, if the vent hole 150 is placed underneath the MEMS IR radiation source 120, as depicted in Figure 7, then the MEMS IR radiation source 120 may comprise a perforated heat dissipating membrane 122 having small holes (c.f. Figure 6) through which the air trapped inside the cavity 131 may flow into the inside of the MEMS IR radiation source 120 and into the vent hole 150 underneath the MEMS IR radiation source 120.

As can be seen, the vent hole 150, 150' may be formed as a hollow channel structure extending perpendicular to the first main surface 101 and/or the second main surface 102 of the substrate 110. This allows for a shortest possible length of the channel-like vent hole 150, 150' to be realized in the substrate 110. Therefore, trapped air can quickly escape.

The vent hole 150, 150' provides for a gas exchange between the cavity 131 of the cavity structure 130 arranged at the first main surface 101 of the substrate 110 and the outside environment 180 at the second main surface 102 of the substrate 110, in particular during the step of curing the adhesive 140, e.g. by applying heat and/or UV radiation. The outside environment 180 may concern the outside environment all around the emitter package 100. However, fluid exchange, and in particular gas exchange, through the vent hole 150, 150' may particularly be realized between the first main surface 101 and the outside environment at the second main surface 102.

Figure 7B shows a bottom view of an assembled emitter package 100 according to the herein described innovative principle. The second main surface 102 may comprise one or more electrical connection regions 191, 192. An electrical connection region may be provided circumferentially around the vent hole 150, 150', as indicated by reference numeral 192. An electrical isolation zone 193 may be provided between the vent hole 150, 150' and the surrounding electrical connection region 192. Accordingly, the electrical connection region 192 may circumferentially surround the vent hole 150, 150' except from an electrical isolation zone 193. The electrical isolation zone 193 may circumferentially surround the vent hole 150, 150'. Additionally or alternatively, the electrical connection regions may be provided spaced apart from the vent hole 150, 150', as indicated by reference numeral 191.

As mentioned before, the emitter package 100 may be a component of a photoacoustic sensor assembly 1000. Figure 8 shows a schematic cross-sectional view of a photoacoustic sensor assembly 1000 according to the herein described innovative principle.

The photoacoustic sensor assembly 1000 comprises an emitter package 100 as described herein. The photoacoustic sensor assembly 1000 may comprise a substrate 1010 and a housing structure 1020 being arranged on the substrate 1010. The housing structure 1020 may provide a cavity 1030 between the walls of the housing structure 1020 and the substrate 1010. The emitter package 100 may be arranged inside said cavity 1030. The MEMS IR radiation source 120 inside the emitter package 100 may be configured to emit IR radiation passing through the lid structure 134 (optionally comprising an IR filter structure) into the cavity 1030.

The photoacoustic sensor assembly 1000 may further comprise a differential pressure sensor 300 being arranged inside the cavity 1030. Said differential pressure sensor 300 may be configured to sense pressure differences inside the cavity 1030 caused by absorption of the emitted IR light by certain gas molecules inside the cavity 1030. The pressure sensor 300 may comprise or be configured as a microphone, and in particular a MEMS microphone.

When the emitter package 100 is readily manufactured, the vent hole 150, 150' may be sealed. The vent hole 150, 150' may be sealed against leakage of pressure sound waves and/or light. As can be seen, the emitter package 100 may be attached to the substrate 1010 of the photoacoustic sensor assembly 1000. For example, the emitter package 100 may be glued or soldered to the substrate 1010 of the photoacoustic sensor assembly 1000.

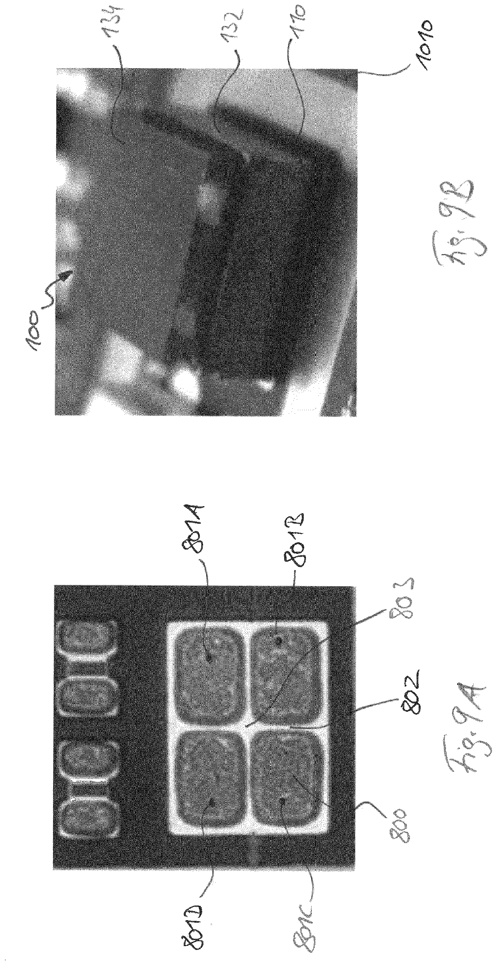

As a non-limiting example, solder material 800 is shown in Figure 8, wherein said solder material 800 may be arranged at an interface between the substrate 110 of the emitter package 100 and the substrate 1010 of the photoacoustic sensor assembly 1000. The solder material 800 may be arranged such that the vent hole 150, 150' may be left uncovered from said solder material 800. Some exemplary embodiments will be described in the following with reference to Figures 9A to 9D. For example, the solder material 800 may be arranged circumferentially around the vent hole 150, 150', i.e. around the perimeter of the vent hole 150, 150'. When heating the solder material 800 previously non-contacting portions of the solder material 800 may be solidified and re-flow so as to merge into each other and form a closed solder-wall around the vent hole 150, 150' in order to seal the vent hole 150, 150' against leakage of sound and/or pressure waves. The solidified solder material 800 may also flow inwardly, i.e. in the direction of the vent hole 150, 150' thereby covering the vent hole 150, 150' at least partially so that the vent hole 150, 150' may be sealed against leakage of sound and/or pressure waves.

Thus, according to an example, the second surface 102 of the substrate 110 may be adhered (e.g. soldered) to the substrate 1010 of the photoacoustic sensor assembly 1000, wherein solder material 800 may be applied between the substrate 110 of the emitter package 100 and the substrate 1010 of the photoacoustic sensor assembly 1000 at an area surrounding or covering the vent hole 150, 150'. Accordingly, when mounting the emitter package 100 to the substrate 1010 of the photoacoustic sensor assembly 1000, the solder material 800 may seal the vent hole 150, 150' such that leakage of sound pressure waves and/or light through the vent hole 150, 150' is prevented.

Alternatively to solder material 800 an adhesive, e.g. a glue, may be used to attach the substrate 110 of the emitter package 100 to the substrate 1010 of the photoacoustic sensor assembly 1000. Accordingly, a respective adhesive and/or solder material 800 may be used for attaching the emitter package 100 to the substrate 1010 of the photoacoustic sensor assembly 1000, and at the same time to seal the vent hole 150, 150' against leakage of pressure sound waves and/or light.

Figure 9A shows a non-limiting example of providing an adhesive or solder material 800 in a particularly advantageous way. Figure 9A shows a top view onto a section of the substrate 1010 of the photoacoustic sensor assembly 1000, and in particular a top view onto a section to which the emitter package 100 may be attached. In other words, Figure 9A shows an interface between the substrate 110 of the emitter package 100 and the substrate 1010 of the photoacoustic sensor assembly 1000.

Accordingly, solder material 800 may be applied at an interface between the substrate 110 of the emitter package 100 and the (corresponding opposing mating surface of the) substrate 1010 of the photoacoustic sensor assembly 1000. That is, the solder material 800 may be applied onto the depicted section of the substrate 1010 of the photoacoustic sensor assembly 1000. Again, instead of the exemplarily described solder material 800, any other adhesive, such as glue, may be used to attach the substrate 110 of the emitter package 100 to the substrate 1010 of the photoacoustic sensor assembly 1000.

According to a non-limiting example, as depicted in Figure 9A, portions of the solder material 800 may be applied in four quadrants 801A, 801B, 801C, 801D. A space 802 may be left between these four solder portion quadrants 801A, ..., 801D. Additionally or alternatively, a space 803 may be left at a region inside the four solder portion quadrants 801A, ..., 801D, i.e. at a region where the corners of all four solder portion quadrants 801A, ..., 801D are opposed to each other.

The emitter package 100 may be positioned onto the solder material 800 such that the vent hole 150 is positioned at the solder material-free space 803 inside the four solder portion quadrants 801A, ..., 801D.

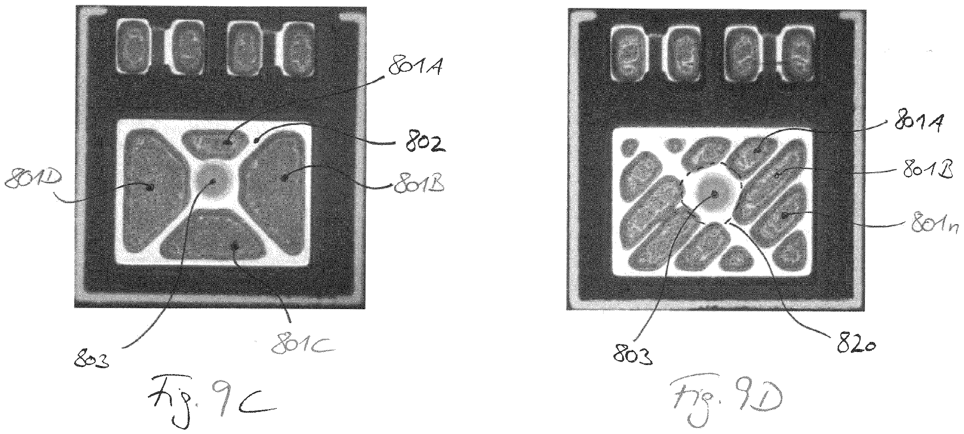

Figure 9C shows a further non-limiting example of a pattern of solder material 800, wherein again the solder material 800 may be applied in four solder portion quadrants 801A, 801B, 801C, 801D. A space 802 may be left between these four solder portion quadrants 801A, ..., 801D. Additionally or alternatively, a space 803 may be left at a region inside the four solder portion quadrants 801A, ..., 801D, i.e. at a region where the corners of all four solder portion quadrants 801A, ..., 801D are opposed to each other.

While in the example of Figure 9A, the four solder portion quadrants 801A, ..., 801D of solder material 800 may comprise a rectangular or square shape, the four solder portion quadrants 801A, ..., 801D of solder material 800 shown in Figure 9C may comprise a trapezoidal shape. Other shapes, such as triangular or circular/oval may also be possible.

Figure 9D shows a further non-limiting example, wherein, alternatively to the above described four solder portion quadrants, a plurality (at least two) of adjacent solder material portions 801A, 801B, ..., 801n may be arranged at the depicted interface between the substrate 110 of the emitter package 100 and the (corresponding opposing mating surface of the) substrate 1010 of the photoacoustic sensor assembly 1000.

In each of the embodiments, the solder portions (e.g. quadrants) 801A, 801B, ..., 801n may be applied circumferentially (see circle 802 in dashed lines) around a free space portion 803 that may be left uncovered from solder material 800, wherein said free space portion 803 may be positioned at a position where the vent hole 150 may be placed upon assembly of the emitter package 100 to the substrate 1010 of the photoacoustic sensor assembly 1000.

The solder material 800 (e.g. solder paste) may be screen printed and the emitter package 100 may be soldered onto the substrate 1010 of the photoacoustic sensor assembly 1000. In order to reduce solder joint voiding and fully seal the vent hole 150, 150', the solder material 800 may be printed through a stencil aperture design using four individual quadrants 801A, ..., 801D, or a pattern of a plurality of adjacent solder material portions 801A, 801B, ..., 801n, as described above. The solder material-free regions or channels 802 between each of the solder paste portions 801A, ..., 801D is to allow flux evaporation and further reduce pressure increase inside the cavity 131 of the emitter package 100 during solder reflow process.

Figure 9B shows a microscopic image of an emitter package 100 being assembled into a photoacoustic sensors assembly 1000. The emitter package 100 comprises the lateral side wall structure 132, inside of which the MEMS IR radiation source 120 is housed, and a lid structure 134 comprising on optional IR filter. The substrate 110 of the emitter package 100 is mounted to the substrate 1010 of the photoacoustic sensors assembly 1000 in a manner as described above.

In order to further enhance the connection between the emitter package 100 and the substrate 1010 of the photoacoustic sensors assembly 1000, and to reduce the risk of the emitter package 100 detaching from the substrate 1010 during subsequent reflow processes, an underfill or non-conductive adhesive (not shown) may be applied around the perimeter of the emitter package 100, preferably after board mount.

The above described step of sealing the vent hole 150, 150' may be performed without applying a vacuum sealing process. Thus, the membrane structure 122 of the MEMS IR radiation source 120 may be protected from being damaged.

The substrate 110 of the emitter package and/or the substrate 1010 of the photoacoustic sensors assembly 1000 may comprise or be configured as a laminate substrate, e.g. a PCB (Printed Circuit Board).

The lateral side wall structure 132 may comprise or be made from an LCP (Liquid Crystal Polymer).

The herein described innovative principle for manufacturing an emitter package 100 and its advantages over common manufacturing methods shall be briefly summarized in other words in the following. The following examples are described with a side wall structure 132 comprising or being made from LCP. However, the below described examples are also valid for side wall structures 132 in general, i.e. for side wall structures 132 that do not contain or be made from LCP.

The herein described innovative principle provides for a cavity package 100 for a MEMS device 120 with improved environmental sealing and a manufacturing method thereof.

It is suggested to provide a vent hole 150, 150' under the cavity 131 of the MEMS die 120 (MEMS IR radiation source). The MEMS die 120 may contain a membrane structure 122 comprising a number of small holes around the outside perimeters of the membrane 122. The package cavity 131 may be connected to the outside environment through the small holes on the membrane 122 and the vent hole 150, 150' on the (e.g. laminate) substrate 110. The diameter of the vent hole 150, 150' on the (laminate) substrate 110 may be between 75 µm to 200 µm.

The advantage of introducing a vent hole 150, 150' on a package substrate 110 is to allow the air inside the package cavity 131 to escape through the small holes on the MEMS membrane 122 and the vent hole 150, 150' on the package substrate 110 during the glue cure No. 2 (LCP side wall 132 to substrate 110 cure). Therefore, the air pressure inside the package cavity 131 will not increase significantly. The glue 140 will not be forced towards the outside to form large blowholes at the LCP to substrate interface.

Using a (laminate) substrate 110 with a vent hole 150 design directly under the MEMS die 120 will ease the pressure increase during the glue cure No. 2 (side wall to substrate glue cure). No significant blowhole is found at the respective interface (side wall to substrate interface).

The vent hole 150, 150' of the PAS emitter package 100 may optionally be sealed when soldered inside the PAS module (photoacoustic sensor assembly) 1000. Sealing may, for instance, be executed using a Sn-Ag-Cu (SAC 305) solder. As a non-limiting example, sealing may be executed such that no leakage of IR signals with wavelengths apart from ∼ 4.2 µm may be detectable. The entire sealing process may be achieved without vacuum seal. Avoiding vacuum sealing means to avoid potential damage to the MEMS membrane 122 under vacuum.

Introducing a vent hole design 150, 150' into the PAS emitter package 100 may significantly increase the cavity package robustness. The system performance of the PAS module 1000 will not be disturbed due to the vent hole sealing in the subsequent module assembly process.

Commonly known solutions for monitoring the odourless and colourless CO₂ gas are bulky and costly or simply not good enough for a widespread adoption. This disclosure enables a reliable and robust CO₂ sensor and saves more than 75 percent space in customer end products compared to commercially available CO₂ sensors. This disclosure also enables to reach an unprecedented manufacturing cost compared to solutions containing LEDs and lasers, which are commonly used as mid-infrared light sources for photoacoustic systems. This innovative concept will not only enable high volume and cost sensitive CO₂ sensing applications, but will also pave the road for the detection of other gases in the future.

Accordingly, this disclosure primarily concerns an infra-red source 100 that may be used in a CO₂ sensor 1000. However, the herein described innovative emitter package 100 may also be used for detection of analytes other than CO₂. The PAS emitter package 100 enables the miniaturization of this gas (e.g. CO₂) sensor 1000. The system 1000 is ideal for smart home applications and building automation as well as indoor air quality loT devices.

The PAS emitter package 100 may be covered by a non-transparent metal lid in the gas (e.g. CO₂) sensor 1000. The metal lid may be glued or soldered onto the sensor substrate 1010.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the herein described innovative concept can be implemented in hardware or in software or at least partially in hardware or at least partially in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the herein described innovative concept comprise a data carrier having electronically readable control signals, which are capable of cooperating with a programmable computer system, such that one of the methods described herein is performed.

Generally, embodiments of the herein described innovative concept can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitory.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the herein described innovative concept comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The methods described herein may be performed using a hardware apparatus, or using a computer, or using a combination of a hardware apparatus and a computer.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A method (400) for manufacturing an emitter package (100) for a photoacoustic sensor assembly (1000), the method comprising:
providing a substrate (110) having a first main surface (101), an opposite second main surface (102), and an opening (150, 150') extending between the first main surface (101) and the second main surface (102) of the substrate (110),
placing a MEMS (MEMS: micro electro mechanical system) infrared radiation source (120) onto the first main surface (101) of the substrate (110),
providing a cavity structure (130) comprising a cavity (131) being surrounded by a lateral side wall structure (132) and a lid (134),
applying an adhesive (140) between the first main surface (101) and the lateral side wall structure (132) and positioning the lateral side wall structure (132) on the adhesive (140), such that the MEMS infrared radiation source (120) is arranged inside said cavity (131) and such that the lateral side wall structure (132) laterally surrounds the opening (150, 150') of the substrate (110), and
curing the adhesive (140).

2. The method (400) according to claim 1,
wherein the step of placing the MEMS infrared radiation source (120) onto the first main surface (101) of the substrate (110) is executed such that the MEMS infrared radiation source (120) is placed above the vent hole (150) or adjacent to the vent hole (150').

3. The method (400) according to claim 1 or 2,
wherein the vent hole (150, 150') comprises the shape of a hollow channel structure extending perpendicular to the first main surface (101) and/or the second main surface (102) of the substrate (110).

4. The method (400) according to any one of claims 1 to 3,
wherein the vent hole (150, 150') provides for a gas exchange between the cavity (131) of the cavity structure (130) at the first main surface (101) of the substrate (110) and the outside environment (180) at the second main surface (102) of the substrate (110) during the step of curing the adhesive (140).

5. The method (400) according to any one of claims 1 to 4,
wherein, after the step of curing the adhesive (140), the method further comprises a step of sealing the vent hole (150, 150').

6. The method (400) according to claim 5,
wherein the step of sealing the vent hole (150, 150') comprises a step of soldering the second surface (102) of the substrate (110) to a further substrate (1010) of the photoacoustic sensor assembly (1000), wherein solder material is applied between the substrate (110) of the cavity structure (130) and the further substrate (1010) of the photoacoustic sensor assembly (1000) at an area surrounding or covering the vent hole (150, 150').

7. The method (400) according to claim 6,
wherein solder material is applied at an interface between the substrate (110) of the cavity structure (130) and the further substrate (1010) of the photoacoustic sensor assembly (1000) in four quadrants (801A, 801B, 801C, 801D) with a space (802, 803) left between these four quadrants (801A, 801B, 801C, 801D).

8. The method (400) according to any one of claims 5 to 7,
wherein the step of sealing the vent hole (150, 150') is performed without applying a vacuum sealing process.

9. The method (400) according to any one of claims 1 to 8,
wherein the method (400) further comprises a step of applying an additional adhesive or underfill material around an outside perimeter of the lateral side wall structure (132) for attaching the lateral side wall structure (132) to the substrate (1010) of the photoacoustic sensors assembly (1000).

10. An emitter package (100) to be used in a photoacoustic sensor assembly (1000), the emitter package (100) comprising:
a substrate (110) having a first main surface (101) and an opposite second main surface (102),
a MEMS infrared radiation source (120) at the first main surface (101) of the substrate (110),
a cavity structure (130) comprising a lid (134) and a cavity (131) being surrounded by a lateral side wall structure (132),
wherein the lateral side wall structure (132) is adhered to the first main surface (101) of the substrate (110) by means of a cured adhesive (140), wherein the MEMS infrared radiation source (120) is arranged inside said cavity (131), and
a vent hole (150, 150') provided in the substrate (110), the vent hole (150, 150') extending between the first main surface (101) and the second main surface (102) of the substrate (110), wherein the vent hole (150, 150') is laterally surrounded by the lateral side wall structure (132).

11. The emitter package (100) according to claim 10,
wherein the vent hole (150) is positioned underneath the MEMS infrared radiation source (120), or wherein the vent hole (150') is positioned adjacent to the MEMS infrared radiation source (120).

12. The emitter package (100) according to claim 10 or 11,
wherein the lateral side wall structure (132) comprises a liquid crystal polymer.

13. The emitter package (100) according to any one of claims 10 to 12,
wherein the MEMS infrared radiation source (120) comprises a perforated heat dissipating membrane (122).

14. The emitter package (100) according to any one of claims 10 to 13,
wherein the vent hole (150, 150') comprises a diameter between 75 µm and 200 µm.

15. A photoacoustic sensor assembly (1000) comprising an emitter package (100) according to any one of claims 10 to 14.
